# EUROPÄISCHE PATENTANMELDUNG

(11) **EP 2 050 567 A2**
(43) Veröffentlichungstag der Anmeldung: **22.04.2009**
(21) Anmeldenummer: 08017683.7
(22) Anmeldetag: 09.10.2008
(51) Int. Cl.: B41F 15/10, B41F 15/16, B41F 21/12, B41F 21/14, B41F 33/00, H05K 3/12

(54) **Verfahren zum Ausrichten von einem zu bedruckenden Trägermaterial**

(30) Priorität: 18.10.2007 DE 102007050319; 05.11.2007 DE 102007053059
(71) Anmelder: I-mation GmbH, 78628 Rottweil (DE)
(72) Erfinder: Prinzing, Rainer, 78628 Rottweil (DE); Hahn, Thomas, 78628 Rottweil (DE); Diethelm, Georg, 78713 Schramberg (DE)
(74) Vertreter: Maser, Jochen

(57) **Zusammenfassung**

Die Erfindung betrifft ein Verfahren zum Ausrichten von einem zu bedruckenden Trägermaterial (16) mit zumindest einer Passmarke (24, 25), welches auf einem Drucktisch (14) aufliegt, wobei vor der Ausrichtphase, die für jedes auf dem Drucktisch (14) aufgelegte Trägermaterial (16) vor dem Druckvorgang durchgeführt wird, zur Ermittlung der Sollposition (28) zumindest einmalig eine Kalibrierphase für den nachfolgenden Druckvorgang durchgeführt wird, in der Kalibrierphase die zumindest eine Passmarke (24, 25) des Trägermaterials (16), welches auf dem Drucktisch (14) aufliegt und zu einem nachfolgenden Druckvorgang ausgerichtet ist, als Sollposition (28) erfasst wird, die zumindest eine Passmarke (24, 25) des Trägermaterials (16) in der Kalibrierphase zumindest einmal aus einer Sollposition (28) in eine Kalibrierposition (29) übergeführt und eine daraus resultierende Abweichung erfasst wird und aus der Abweichung zwischen der Sollposition (28) und der Kalibrierposition (29) sowie den dafür erforderlichen Stellgrößen zum Verfahren des Drucktisches (14) eine Übertragungsfunktion ermittelt wird.

## Beschreibung

Die Erfindung betrifft ein Verfahren zum Ausrichten von einem zu bedruckenden Trägermaterial mit zumindest einer Passmarke, welches auf einem Drucktisch aufliegt, gemäß dem Oberbegriff des Anspruchs 1.

Aus der DE 39 04 863 A1 geht eine Flachbett-Siebdruckmaschine hervor, bei der beim erneuten Einlegen einer Leiterplatte zum Bedrucken mit einem zweiten Druckbild ein exakter und individueller Abgleich der Lage der Leiterplatte vorgesehen ist, so dass eine exakte Übereinstimmung des zweiten Druckbildes mit dem ersten Druckbild erfolgt. Dabei sind oberhalb eines Drucktisches zwei Kameras vorgesehen, die mit einer Steuereinrichtung in Verbindung stehen. Nach dem erneuten Auflegen der Leiterplatte auf einen Drucktisch zum Aufbringen des zweiten Druckbildes wird die Istlage von Referenzmarken auf der Leiterplatte erfasst.

Anschließend vergleicht die Steuereinrichtung die Istlage der Referenzmarken mit einer zuvor erfassten und abgespeicherten Solllage der Referenzmarken der Leiterplatte für das vorherige Druckbild. Aus dem Vergleich der Ist- und der Solllage wird ein Steuersignal abgeleitet, welches Schrittmotoren des Drucktisches ansteuert, um den Drucktisch so lange zu verfahren, bis eine Übereinstimmung von der Istlage der Referenzmarken der erneut aufgelegten Leiterplatte mit der zuvor erfassten Solllage der Referenzmarken gegeben ist. Diese Ansteuerung der Schrittmotoren zum Verfahren des Drucktisches aus der Istlage in die zuvor erfasste Solllage wird dabei durch die Kameras überwacht und erst dann gestoppt, wenn die Kameras die Referenzmarken der erneut aufgelegten Leiterplatte in der zuvor erfassten Sollmarke ermitteln.

Diese rechnergesteuerte Überwachung des Druckvorganges erlaubt zwar eine vollautomatische Arbeitsweise, jedoch ist durch diese Art der Steuerung eine zeitaufwändige Einstellung gegeben, da fortwährend die aktuelle Istlage der Referenzmarken durch die Kamera erfasst und mit der zuvor eingestellten Solllage verglichen wird, um in Abhängigkeit der daraus ermittelten Abweichung erneut die Stellmotoren anzusteuern.

Der Erfindung liegt deshalb die Aufgabe zugrunde, ein Verfahren zum Ausrichten von einem zu bedruckenden Trägermaterial mit zumindest einer Passmarke, welches auf einem Drucktisch aufgelegt und zum Bedrucken mit einem ersten oder weiteren Druckbild vorgesehen ist, vorzuschlagen, welches einen exakten Abgleich der Lage automatisch und schnell ermöglicht.

Diese Aufgabe wird erfindungsgemäß durch die Merkmale des Anspruchs 1 gelöst. Weitere vorteilhafte Ausgestaltungen und Weiterbildungen sind in den weiteren Ansprüchen angegeben.

Durch die erfindungsgemäße Kalibrierphase wird eine definierte Ausrichtung von dem zu bedruckenden Trägermaterial mit einem weiteren Druckbild ermöglicht, bei dem die Übereinstimmung einer Istposition der zumindest einen Passmarke des Trägermaterials mit einer Sollposition eines vorausgegangenen Druckbildes oder eines herzustellenden Druckbildes ohne Überwachung des Verfahrweges bei einer ermittelten Abweichung ermöglicht ist. Es genügt eine einmalige Ausgabe von Stellgrößen an die Stellantriebe, um die ermittelte Abweichung auszugleichen. Hierzu wird in der Kalibrierphase zumindest eine Abweichung von der zumindest einen Passmarke des Trägermaterials aus einer Sollposition, die zunächst als solche erfasst wird, in eine Kalibrierposition angesteuert, wobei diese Abweichung bestehend aus Absolutwert und Richtung einerseits erfasst wird und die erforderlichen Stellgrößen zum Verfahren des Drucktisches andererseits erfasst werden und daraus eine Übertragungsfunktion ermittelt wird. Durch die Ermittlung dieser Übertragungsfunktion wird somit ermöglicht, dass die Ausgabe von Stellgrößen zur Ansteuerung des Drucktisches eine definierte Stellbewegung zum Ausgleich der Abweichung bewirken, das heißt, dass sowohl die Überwachung des Verfahrweges zum Ausgleich der ermittelten Abweichung als auch die Einnahme der Endlage beziehungsweise der Sollposition der zumindest einen Passmarke des auf dem Drucktisch aufgelegten Trägermaterials nicht mehr erforderlich ist. Dadurch kann eine schnelle und exakte Einstellung der Sollposition während der Ausrichtphase angesteuert werden. Die Sollposition der zumindest einen Passmarke des Trägermaterials, von der aus die Kalibrierphase gestartet wird, kann auf das herzustellende oder nachfolgende Druckbild abgestimmt und exakt eingestellt werden.

Nach einer bevorzugten Ausgestaltung des Verfahrens ist vorgesehen, dass die Abweichung der Kalibrierposition zur Sollposition durch zumindest eine Positionserfassungseinrichtung, insbesondere CCD-Kamera, erfasst wird. Dadurch kann eine schnelle und einfache Erfassung ermöglicht werden.

Nach einer weiteren vorteilhaften Ausgestaltung des Verfahrens ist vorgesehen, dass die angesteuerte Abweichung zwischen der Sollposition und der Kalibrierposition während der Kalibrierphase zumindest einen Versatz in X- oder Y-Richtung erfasst. Dadurch kann die Übertragungsfunktion ermittelt werden, indem eine in X- oder Y-Richtung erfolgende Verfahrstrecke den Stellgrößen der Stellantriebe zugeordnet wird. Bevorzugt ist vorgesehen, dass ein Versatz in X- und Y-Richtung erfolgt, so dass die Abweichung aus Absolutwert und Richtung in Relation zu Daten der eingesetzten Positionserfassungseinrichtung und Stellgrößen der Stellantriebe erfasst wird.

Nach einer bevorzugten Ausgestaltung des Verfahrens ist vorgesehen, dass zumindest zwei Positionserfassungseinrichtungen eingesetzt und angesteuert werden und durch jede Positionserfassungseinrichtung eine Passmarke erfasst wird. Dadurch kann die Kalibrierung exakt durchgeführt werden. Daraus resultiert, dass während der Ausrichtphase das zu bedruckende Trägermaterial exakter auf die Sollposition ausgerichtet wird. Insbesondere sind die zumindest zwei Passmarken entfernt zueinander angeordnet, so dass auch geringe Abweichungen, insbesondere Winkelabweichungen, exakt ermittelt werden können.

Nach einer weiteren bevorzugten Ausgestaltung des Verfahrens ist vorgesehen, dass die Übertragungsfunktion aus einem Verhältnis aus einer betragsmäßigen Anzahl von Pixeln der Positionserfassungseinrichtung und der Stellgrößen des oder der Stellantriebe zum Verfahren des Drucktisches gebildet wird. Dadurch wird der Verfahrweg beim Erfassen einer Abweichung von den Toleranzen der Antriebe des Drucktisches und der Positionserfassungseinrichtungen unabhängig. Darüber hinaus ist es auch nicht erforderlich, die Positionserfassungseinrichtung in einer exakten Position zum Drucktisch auszurichten, da aufgrund der Kalibrierphase eine betragsmäßige Abweichung der Sollposition zur Kalibrierposition einem Betrag an Stellgrößen beziehungsweise maschinengesteuerten Daten zur Ansteuerung des Drucktisches zugeordnet wird. Da von der Positionserfassungseinrichtung vor dem Beginn der Kalibrierphase die exakte Sollposition eingelesen und abgespeichert wurde, kann in der nachfolgenden Ausrichtphase eine einfache Ermittlung der Abweichung zwischen der Istposition und der Sollposition erfolgen und aufgrund der Kalibrierung eine definierte Ausgabe von Stellgrößen beziehungsweise maschinengesteuerten Daten für die Stellantriebe zum Ausgleich der Abweichung ausgegeben werden.

Eine bevorzugte Ausgestaltung des Verfahrens sieht vor, dass innerhalb einer Kalibrierphase mehrere Abweichungen zwischen einer Sollposition und einer Kalibrierposition angesteuert und erfasst werden, um aus der Summe der einzelnen Abweichungen eine gemittelte Abweichung zu erfassen. Dadurch kann die Genauigkeit der Bestimmung der Abweichung erhöht und somit die Ansteuerung der Verfahrwege durch die Stellantriebe präzisiert werden. Dabei kann vorgesehen sein, dass die Abweichung mehrmals zwischen der Sollposition und derselben Kalibrierposition erfolgt. Alternativ kann vorgesehen sein, dass unterschiedliche Kalibrierpositionen ausgehend von derselben Sollposition angesteuert werden. Durch diese Vorgehensweise lassen sich insbesondere Fehler der Komponenten einer Vorrichtung zum Bedrucken eliminieren, wie beispielsweise Objektivfehler von Positionserfassungseinrichtungen.

Die Kalibrierphase umfasst gemäß einer weiteren bevorzugten Ausgestaltung des Verfahrens die Erfassung eines Versatzes zumindest einer Farbmarke von zumindest einer Vorrichtung für ein Druckmotiv, insbesondere einen Siebversatz. Ein solcher Siebversatz wird bei einer gegebenen Abweichung zwischen einer gedruckten Farbmarke und deren Sollposition erfasst. Dadurch kann eine Ungenauigkeit im Einstellen einer beispielsweise Siebschablone für ein weiteres Druckmotiv erfasst und in der nachfolgenden Ausrichtphase berücksichtigt werden. Dieser Versatz wird bevorzugt elektronisch ermittelt. Alternativ kann in der Kalibrierphase auch vorgesehen sein, dass die Sollposition der Farbmarke erfasst wird und durch Ansteuerung der Stellantriebe ein Verfahrweg in die Istposition der Farbmarke, um dann daraus die Stellgrößen für die Stellantriebe für diesen Versatz abzuleiten.

Nach einer weiteren bevorzugten Ausgestaltung des Verfahrens ist vorgesehen, dass zur Ausrichtung des Drucktisches für den Ausgleich der ermittelten Abweichung aus der Sollposition aus einer Umkehrfunktion der Übertragungsfunktion die Daten zur Ansteuerung des Drucktisches ermittelt werden. Dadurch werden kalibrierte Daten für die Ansteuerung des Drucktisches ausgegeben.

Bevorzugt wird die Ausgabe der Stellgrößen zur Ausrichtung des Drucktisches während einem Verfahren des Drucktisches aus einer Bestückposition in eine Druckposition ausgegeben, so dass während dem Umsetzen des Drucktisches gleichzeitig der Abgleich von Soll- und Istposition erfolgt. Alternativ können die Stellgrößen auch nach dem Auflegen des Trägermaterials auf dem Drucktisch in der Bestückposition ausgegeben werden, bevor ein Umsetzen des Drucktisches in die Druckposition erfolgt.

Die Erfindung sowie weitere vorteilhafte Ausführungsformen und Weiterbildungen derselben werden im Folgenden anhand der in den Zeichnungen dargestellten Beispiele näher beschrieben und erläutert. Die der Beschreibung und den Zeichnungen zu entnehmenden Merkmale können einzeln für sich oder zu mehreren in beliebiger Kombination erfindungsgemäß angewandt werden. Es zeigen:
- Figur 1: eine schematische Seitenansicht einer Arbeitsstation einer Druckmaschine und
- Figur 2: eine schematische Ansicht von oben auf einen Drucktisch gemäß Figur 1.

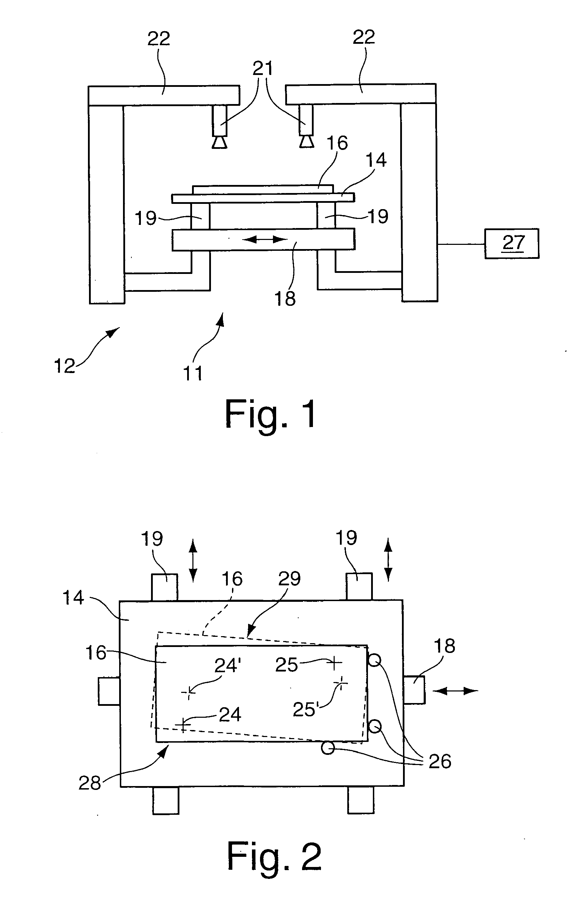

In Figur 1 ist eine schematische Seitenansicht einer Arbeitsstation 11 einer Druckvorrichtung 12 dargestellt. Die nicht näher dargestellte Druckvorrichtung 12 kann beispielsweise als eine Siebdruckmaschine, eine Druckmaschine für Leiterbahnen, eine Beschichtungsmaschine für flüssige Medien oder einzelne Partikel, wie beispielsweise Beflockung oder dergleichen, ausgebildet sein. Die Arbeitsstation 11 besteht aus einem Drucktisch 14, auf welchen ein Trägermaterial 16 für einen nachfolgenden Druckvorgang aufgelegt wird. Dieser Druckvorgang kann sowohl das Aufdrucken oder Aufbringen von Materialien als auch das Beschichten oder Belichten umfassen. Der Drucktisch 14 ist in der Arbeitsstation 11 in einer Bestückposition angeordnet. Der Drucktisch 14 ist als X-Y-Achsentisch ausgebildet und weist zumindest einen Stellantrieb 18 in X- und zumindest einen Stellantrieb 19 in Y-Richtung auf. Bevorzugt sind in einer Achse zwei Stellantriebe 19 und in der weiteren Achse nur ein Stellantrieb 18 vorgesehen, um auch eine Drehbewegung um eine Z-Achse in den Drucktisch 13 einzuleiten. Oberhalb des Drucktisches 14 sind zwei Positionserfassungseinrichtungen 21 in ihrer Position frei wählbar an einem Gestell 22 der Arbeitsstation 11 angeordnet. Diese Positionserfassungseinrichtungen 21 sind als Kameras, insbesondere CCD-Kameras, ausgebildet und erfassen die Lage von zumindest einer, vorzugsweise zwei, auf dem Trägermaterial 16 angeordneten Passmarken 24, 25, die beispielhaft als Kreuz ausgebildet sind. Weitere geometrische Formen können ebenfalls vorgesehen sein. Diese Positionserfassungseinrichtungen 21 sowie die Stellantriebe 18, 19 sind mit einer Rechen- und Steuereinheit 27 verbunden.

Das Trägermaterial 16, welches zum Bedrucken vorgesehen ist, kann vielfältig ausgebildet und aus unterschiedlichen Materialien bestehen. Beispielsweise können Folien, Papier, Textilien, bahnförmige Materialien, wie Stoffe, Gewebe, Vliese als auch Leiterplatten und dergleichen als Trägermaterial eingesetzt werden.

Die Ausrichtung des Trägermaterials 16 auf dem Drucktisch 14 in einer Sollposition 28 ist deshalb erforderlich, um in einer nicht näher dargestellten Druckstation ein Druckbild auf eine exakt vorbestimmte Lage des Trägermaterials 16 aufzubringen. Beispielsweise wird bei einem Mehrfarbendruck, insbesondere Siebdruck, ein Motiv oft aus mehreren Farbkomponenten zusammengesetzt, wobei jede Farbkomponente in einem separaten Druckvorgang aufgetragen wird. Damit die Farben sich bei dem aufeinanderfolgenden Aufbringen der einzelnen Druckbilder nicht vermischen oder ungewollte Zwischenräume entstehen, ist die exakte Ausrichtung des Trägermaterials 16 auf die Sollposition 28 erforderlich, zumal das Trägermaterial 16 nach jedem Druckvorgang entweder erneut auf einem Drucktisch 14 aufgelegt wird oder die Position des Drucktisches 14 vor dem nächsten Arbeitsgang nochmals abgefragt werden muss. Ein solcher Druckvorgang läuft wie folgt ab:

Auf den Drucktisch 14 wird das Trägermaterial 16 aufgelegt. Bevorzugt sind Ausrichthilfen 26 auf dem Drucktisch 14 vorgesehen, um eine definierte Anlage des Trägermaterials 16 an den Ausrichthilfen 26 zu ermöglichen. Bevorzugt sind drei Ausrichthilfen 26 zur definierten Anlage vorgesehen. Anschließend wird die Istposition des aufgelegten Trägermaterials 16 über die Positionserfassungseinrichtungen 21 aufgrund der Lage der Passmarken 24, 25 erfasst. Eine Abweichung einer Istposition von der Sollposition 28 wird durch die Rechen- und Steuereinheit 27 ermittelt. Beim Vorliegen einer Abweichung gibt die Rechen- und Steuereinheit 27 Stellgrößen beziehungsweise maschinengesteuerte Daten an die Stellantriebe 18, 19 aus, um die Abweichung auszugleichen. Anschließend wird der Drucktisch 14 aus der Arbeitsstation 11 in die Druckstation übergeführt. Nach dem Druckvorgang wird der Drucktisch 14 wieder in die Arbeitsstation 11 zurückgeführt und das Trägermaterial 16 entnommen. Alternativ kann der Drucktisch 14 auch in eine weitere Arbeitsstation übergeführt werden, um weitere Arbeitsschritte durchzuführen.

Damit eine solche Ausrichtphase, die nach dem Auflegen des Trägermaterials 16 mit der Erfassung der Lage der Passmarke 24, 26 beginnt und vor dem Druckvorgang beendet ist, eine exakte Kompensation bei einer gegebenenfalls vorliegenden Abweichung der zumindest einen Passmarke 24, 25 des zu bedruckenden Trägermaterials 16 von einer Sollposition 28 ermöglicht, wird zuvor erfindungsgemäß eine Kalibrierphase durchgeführt. Eine solche Kalibrierphase braucht nur einmalig für den oder die nachfolgenden Druckvorgänge mit demselben Druckmotiv oder Druckformat durchgeführt zu werden. Im Anschluss daran können sich beliebig viele Ausrichtphasen zum Bedrucken der Trägermaterialien 16 anschließen.

Die Kalibrierphase umfasst folgende Schritte in Bezug auf Figur 2: Nachdem ein auf dem Drucktisch 14 aufliegendes Trägermaterial 16 exakt auf das aufzubringende oder weitere beziehungsweise nachfolgende Druckbild eingerichtet beziehungsweise ausgerichtet wurde, beginnt die Kalibrierphase, wobei dieses ausgerichtete Trägermaterial 16 auf dem Drucktisch 14 verbleibt. Die Position der Passmarken 24, 25 wird durch die Positionserfassungseinrichtungen 21 erfasst und in der Rechen- und Steuereinheit 27 der Sollposition 28 abgespeichert. Im Anschluss daran wird durch die Rechen- und Steuereinheit 27 eine Abweichung in der Lage von zumindest einer Passmarke 24, 25 herbeigeführt, das heißt, dass die Passmarken 24, 25 aus der Sollposition 28 in eine Kalibrierposition 29 übergeführt werden. Anschließend wird die Lage der zumindest einen Passmarke 24', 25' in der Kalibrierposition 29 durch die Positionserfassungseinrichtungen 21 ermittelt. In der Rechen- und Steuereinheit 27 wird diese Kalibrierposition 29 gegenüber der Sollposition 28 als Abweichung bestehend aus einem Absolutwert und einer Richtung ermittelt. Gleichzeitig die für diese Abweichung erforderlichen Stellgrößen der Stellantriebe 18, 19 erfasst und in Relation dazu gesetzt, um daraus eine Übertragungsfunktion zu ermitteln. Somit wird eine Abweichung einer Kalibrierposition 29 zu einer Sollposition 28 exakt in Abhängigkeit der Auflösung der Positionserfassungseinrichtung 21 als auch den Stellgrößen der Stellantriebe 18, 19 und in Abhängigkeit der Lage der Passmarken 24, 25 zueinander ermittelt. Es können somit durch eine Umkehrfunktion aus der Übertragungsfunktion exakt definierte Verfahrwege abgeleitet und angesteuert werden. Diese Übertragungsfunktion wird abgespeichert, und die Kalibrierphase ist abgeschlossen.

Die Kalibrierphase kann vorteilhafterweise dahingehend modifiziert werden, dass die angesteuerte Abweichung zwischen die Sollposition 28 der Passmarke 24, 25 in die Kalibrierposition 29 mehrmals erfolgt. Dadurch kann ein Array von Übertragungsfunktionen ermittelt werden, um beispielsweise Fehler des Aufbaus in der Vorrichtung und/oder deren Komponenten zu eliminieren, insbesondere um Objektivfehler der Positionserfassungseinrichtung 21 zu eliminieren. Die Kalibrierposition 29 kann dabei auch in verschiedenen Abständen und/oder Richtungen von der Sollposition 28 liegen, um die erforderlichen Stellgrößen der Stellantriebe 18, 19 für die jeweilige Abweichung zu ermitteln.

Die Kalibrierphase kann gemäß einer vorteilhaften Ausführungsform des Weiteren einen Fehler einer Vorrichtung für ein Druckmotiv, insbesondere eine Druckschablone für das nachfolgende Druckbild oder Druckmotiv, berücksichtigen. Dadurch kann ein möglicher Versatz in der Einstellung der Vorrichtung, insbesondere eines Rahmens für eine Druckschablone oder einer Druckschablone, ermittelt werden. Zur Ermittlung dieser gegebenenfalls vorliegenden Abweichung wird ein Druckmotiv auf ein bereits auf dem Drucktisch 14 aufliegendes Trägermaterial 16 aufgebracht. Anschließend wird der Drucktisch 14 wieder in eine Ausgangsposition zurückgeführt, um zunächst die Sollposition 28 der Passmarke 24, 25 zu erfassen und abzuspeichern. Anschließend wird der Versatz einer Farbmarke der Vorrichtung für ein Druckmotiv ermittelt, welche zum Beispiel in einer Sollposition einen definierten Abstand zur Passmarke 24, 25 aufweist. Die Abweichung von diesem definierten Abstand der Farbmarke zur Passmarke 24, 25 wird elektronisch erfasst und abgespeichert. Alternativ kann eine solche Abweichung der Farbmarke in Analogie zur vorbeschriebenen Ermittlung der Abweichung der Passmarke 24, 25 gegenüber der Sollposition zur Kalibrierposition ermittelt werden. Die Kalibrierphase kann somit nicht nur eine gegebenenfalls vorliegende Abweichung des Druckbildes für den nachfolgenden Druckvorgang umfassen, sondern auch einen Versatz der Vorrichtung für ein Druckmotiv. Beide erfassten Abweichungen werden von der Übertragungsfunktion erfasst und abgespeichert, wobei zunächst die Abweichung der Passmarke 24, 25 zwischen der Soll- und Kalibrierposition 28, 29 erfasst wird und anschließend ein möglicher Versatz der Vorrichtung für ein Druckmotiv überlagert wird, um die Übertragungsfunktion zu bilden.

Anschließend wird das Trägermaterial 16 vom Drucktisch 14 entnommen, und die Ausrichtphase für ein neu aufzulegendes Trägermaterial 16 kann beginnen. Durch die Abspeicherung der Sollposition 28 der Passmarken 24, 25 zu Beginn der Kalibrierphase ist es nicht erforderlich, die Positionserfassungseinrichtungen 21 exakt auszurichten. Es ist lediglich erforderlich, dass die Passmarke 24, 25 innerhalb des Aufnahmebereiches der Positionserfassungseinrichtung 21 liegt. Darüber hinaus weist diese Kalibrierphase den Vorteil auf, dass zum Ausrichten des Trägermaterials 16 auf die Sollposition 28 während der Ausrichtphase nur ein Bild pro Positionserfassungseinrichtung 21 erforderlich ist, um die gegebenenfalls vorliegende Abweichung der Istposition von der Sollposition 28 zu bestimmen. Anschließend werden zum Kompensieren der Abweichung maschinengesteuerte Daten beziehungsweise Stellgrößen der Stellantriebe 18, 19 aus einer Umkehrfunktion der Übertragungsfunktion ermittelt und ausgegeben. Nach Erreichen der Endposition der Stellantriebe 18, 19 aufgrund der durch die Umkehrfunktion ermittelten maschinengesteuerten Daten ist keine weitere Erfassung oder Überwachung der aktuellen Position mehr erforderlich, da aufgrund der vorherigen Kalibrierphase eine exakte Einstellung sichergestellt ist. Dadurch können weitere zeitaufwändige Regelabstimmungen zwischen der Positionserfassungseinrichtung und den erfolgten Stellwegen der Stellantriebe und gegebenenfalls weitere Parameterabstimmungen entfallen. Darüber hinaus lassen sich mögliche optische Fehler ebenso eliminieren wie zum Beispiel nicht orthogonal zueinanderstehende Positionsachsen der Positionserfassungseinrichtung 21 zum Drucktisch 14 und/oder zu den Ausrichtachsen der Stellantriebe 18, 19.

Bei dem vorbeschriebenen Ausführungsbeispiel sind bevorzugt zwei Positionserfassungseinrichtungen 21 beschrieben, durch die jeweils die Position einer Passmarke 24, 25 erfasst und der Rechen- und Steuereinheit 27 zugeführt wird. Bei der Überführung der Passmarken 24, 25 aus einer Sollposition 28 in eine Kalibrierposition 29 während der Kalibrierphase wird durch jede Positionserfassungseinrichtung 21 die Position der jeweiligen Passmarken 23, 24 in der Kalibrierphase erfasst. Aufgrund der Bildung der Übertragungsfunktion über die erforderlichen Stellgröße für die Stellantriebe 18, 19 zum Überführen der Passmarken 24', 25' in die Kalibrierposition 29 kann eine definierte Zuordnung und Erfassung der Abweichung erfolgen, ohne dass die exakte Lage der Positionserfassungseinrichtung 21 zum Drucktisch zu berücksichtigen ist.

Die Durchführung des erfindungsgemäßen Verfahrens ist auch mit nur einer Passmarke 24 auf dem Trägermaterial 16 ermöglicht. Die Passmarke 24 ist dabei bevorzugt als Kreuz ausgebildet, so dass sowohl Abweichungen in X- als auch Y-Richtung als auch eine Verdrehung, das heißt, eine Abweichung in X- und Y-Richtung, erfasst werden können. Bevorzugt ist eine solche Passmarke 24 im Verhältnis größer ausgebildet als beim Einsatz von zwei Passmarken 24, 25, um insbesondere eine Winkelabweichung zu erfassen.

## Patentansprüche

1. Verfahren zum Ausrichten von einem zu bedruckenden Trägermaterial (16) mit zumindest einer Passmarke (24, 25), welches auf einem Drucktisch (14) aufliegt,
- bei dem während einer Ausrichtphase nach dem Auflegen des Trägermaterials (16) auf den Drucktisch (14) die Lage der zumindest einen Passmarke (24, 25) auf dem Trägermaterial (16) als Istposition erfasst wird,
- bei dem die Istposition der zumindest einen Passmarke (24, 25) mit einer Sollposition (28) verglichen wird und
- bei dem bei einer Abweichung der Istposition von der Sollposition (28) Stellgrößen zur Ausrichtung des Drucktisches (14) auf die Sollposition (28) der zumindest einen Passmarke (24, 25) ausgegeben werden,
**dadurch gekennzeichnet,**
- **dass** vor der Ausrichtphase, die für jedes auf dem Drucktisch (14) aufgelegte Trägermaterial (16) vor dem Druckvorgang durchgeführt wird, zur Ermittlung der Sollposition (28) zumindest einmalig eine Kalibrierphase für den nachfolgenden Druckvorgang durchgeführt wird,
- **dass** in der Kalibrierphase die zumindest eine Passmarke (24, 25) des Trägermaterials (16), welches auf dem Drucktisch (14) aufliegt und zu einem nachfolgenden Druckvorgang ausgerichtet ist, als Sollposition (28) erfasst wird,
- **dass** die zumindest eine Passmarke (24, 25) des Trägermaterials (16) in der Kalibrierphase zumindest einmal aus einer Sollposition (28) in eine Kalibrierposition (29) übergeführt und eine daraus resultierende Abweichung erfasst wird und
- **dass** aus der Abweichung zwischen der Sollposition (28) und der Kalibrierposition (29) sowie den dafür erforderlichen Stellgrößen zum Verfahren des Drucktisches (14) eine Übertragungsfunktion ermittelt wird.

2. Verfahren nach Anspruch 1, **dadurch gekennzeichnet, dass** die Abweichung der Kalibrierposition (29) zur Sollposition (28) durch zumindest eine Positionserfassungseinrichtung (21) erfasst wird.

3. Verfahren nach Anspruch 1 oder 2, **dadurch gekennzeichnet, dass** die Abweichung zwischen der Sollposition (28) und der Kalibrierposition (29) zumindest durch einen Versatz in X-Richtung oder Y-Richtung bestimmt wird.

4. Verfahren nach Anspruch 2, **dadurch gekennzeichnet, dass** zumindest zwei Positionserfassungseinrichtungen (21) angesteuert werden und durch jede Positionserfassungseinrichtung (21) eine Passmarke (24, 25) auf dem Trägermaterial (16) erfasst wird.

5. Verfahren nach Anspruch 1, **dadurch gekennzeichnet, dass** die Übertragungsfunktion aus einem Verhältnis aus einer betragsmäßigen Anzahl von Pixeln der Positionserfassungseinrichtung (21) und der Stellgröße von jedem Stellantrieb (18, 19) zum Verfahren des Drucktisches (14) gebildet wird.

6. Verfahren nach Anspruch 1, **dadurch gekennzeichnet, dass** in der Kalibrierphase mehrmalig eine Verfahrstrecke zwischen der Sollposition (28) und einer Kalibrierposition (29) der Passmarke (24, 25) erfasst wird.

7. Verfahren nach Anspruch 1, **dadurch gekennzeichnet, dass** in der Kalibrierphase ein Versatz von zumindest einer Farbmarke von einer Vorrichtung für ein Druckmotiv zur Sollposition der zumindest einen Passmarke erfasst wird.

8. Verfahren nach einem der vorhergehenden Ansprüche, **dadurch gekennzeichnet, dass** die Ermittlung der Übertragungsfunktion unabhängig von der exakten Position der zumindest einen Positionserfassungseinrichtung (21) zum Drucktisch (14) ermittelt wird.

9. Verfahren nach einem der vorhergehenden Ansprüche, **dadurch gekennzeichnet, dass** die Stellgrößen zur Ausrichtung des Drucktisches (14) zum Ausgleich einer ermittelten Abweichung aus der Sollposition (28) aus einer Umkehrfunktion der Übertragungsfunktion ermittelt werden.

10. Verfahren nach einem der vorhergehenden Ansprüche, **dadurch gekennzeichnet, dass** die Ansteuerung des Drucktisches (14) bei Feststellung einer ermittelten Abweichung von der Sollposition (28) in eine Bestückposition des Drucktisches (14) oder während einer Verfahrbewegung des Drucktisches (14) von der Bestückposition in eine Druckposition durchgeführt wird.
